# EUROPEAN PATENT APPLICATION

(11) **EP 4 456 142 A1**
(43) Date of publication of application: **30.10.2024**
(21) Application number: 23170769.6
(22) Date of filing: 28.04.2023
(51) Int. Cl.: H01L 29/40, H01L 29/41, H01L 29/78, H01L 21/336, H01L 21/311

(54) **FORMING OF SLOPE LINERS IN TRENCH BASED SEMICONDUCTOR DEVICES**

(71) Applicant: Nexperia B.V., 6534 AB Nijmegen (NL)
(72) Inventor: Chen, Fan, Shanghai (CN); Yin, Randy, Shanghai (CN); Ilyas, Nasir, Shanghai (CN)
(74) Representative: Pjanovic, Ilija

(57) **Abstract**

A method of manufacturing a semiconductor device, comprising: forming a region of semiconductor material having a surface; forming a trench extending from the surface into the region of semiconductor material; depositing a first oxide along an inner wall of the trench, the first oxide forming a first slob liner and having a first etch-back ratio; depositing a second oxide along the first oxide that has been deposited along the inner wall of the trench, the second oxide forming a second slob liner and having a second etch-back ratio that is higher than the first etch-back ratio; and etching back the first oxide and the second oxide at the same time to form a slope morphology comprising the first oxide and the second oxide within the trench.

## Description

### Technical field

The present disclosure relates to a method of manufacturing a semiconductor device and a semiconductor device manufactured using such method. More specifically, the present disclosure relates to forming slope liner oxide in a trench of a semiconductor device.

### Background

SGT-MOS and U-MOS are types of Metal-Oxide-Semiconductor Field-Effect Transistors (MOSFETs), which are widely used in electronic circuits as switches and amplifiers.

SGT-MOS stands for "Silicon-Gate Trench MOS" and refers to a type of MOSFET that has a trench structure etched into the silicon substrate. The trench is filled with a conductive material, such as polysilicon or metal, to form the gate electrode. The trench structure allows for a larger gate area, which in turn provides better control over the transistor's performance. SGT-MOS devices are typically used in high-voltage and high-power applications, such as power supplies and motor control circuits.

U-MOS stands for "Ultra-low ON-resistance MOS" and refers to a type of MOSFET that is designed to minimize the resistance between the drain and source terminals when the transistor is switched on. This is achieved by optimizing the doping concentration and thickness of the different layers of the MOSFET, such as the source, drain, and channel regions. The result is a MOSFET with very low ON-resistance, which means it can handle higher currents with less power dissipation. U-MOS devices are typically used in low-voltage and high-current applications, such as battery-powered devices and DC-DC converters.

Figure of merit (FOM) is a performance metric used to compare the performance of different MOSFETs in terms of their trade-offs between drain-source ON-resistance and gate charge. The FOM value is typically expressed in terms of RDS(on) * Qg, where Rds(on) is the drain-source on-state resistance of the MOSFET and Qg is the gate charge. The FOM value may be expressed otherwise, e.g., as BV²/Rds(on), wherein BV is the break down voltage. A higher FOM value indicates a MOSFET with higher breakdown voltage and/or lower on-resistance, which means that it can handle higher voltages and is more efficient in converting electrical power. This is important in many applications, such as power electronics, where efficiency and high power handling capabilities can be critical. Therefore, a better FOM value is desirable for MOSFETs because it indicates that the device is more efficient and can handle higher power levels.

Trenches are a feature of MOSFET design that can improve device performance by reducing on-state resistance and improving breakdown voltage. Trenches are relatively deep, narrow cavities that are etched into the silicon substrate to form the MOSFET channel. Trenches can help to improve the FOM by reducing the on-state resistance and gate charge of the device

A gate electrode may be formed by etching a trench into the silicon substrate and then filling the trench with a conductive material, such as polysilicon or metal. A gate electrode may be wrapped around the vertical sides of the trench, providing more surface area for the gate to control the flow of current through the transistor. This allows for better performance in high-voltage and high-current applications, such as power supplies and motor control circuits. Furthermore, trenches may reduce the electric field strength in the MOSFET, which can improve its reliability and longevity. In a planar MOSFET, the electric field is concentrated at the edges of the gate electrode, which can lead to breakdown and failure over time. In a trench MOSFET, the gate electrode is surrounded by the silicon substrate, which helps to distribute the electric field more evenly and reduce the risk of breakdown.

In known processes of creating trenches, a series of masks is used to define and etch the trench structures into the semiconductor substrate. The process typically begins with the deposition of a layer of oxide on the substrate, which serves as a hard mask layer. A photoresist material may then be applied on top of the oxide layer, and exposed to ultraviolet light through a mask that defines the trench pattern. This step transfers the pattern of the mask onto the photoresist, leaving exposed areas where the trench will be etched. The exposed areas of the photoresist may then be developed, which removes the unwanted photoresist and leaves the patterned photoresist that will be used as a mask for the oxide layer. The exposed areas of the oxide layer may then be etched away using a plasma or wet etching process, using the patterned photoresist as a mask to define the trench structures. After the trench structures are etched into the oxide layer, the photoresist mask may be stripped away using a solvent or plasma process, leaving the patterned oxide layer that will be used as a mask for the next step in the process. The substrate may then be subjected to a selective epitaxial growth process, which deposits a layer of silicon in the trench structures, creating a raised source and drain structure for the SGT-MOS device.

Slop liner is a term that refers to the thin layer of oxide that is intentionally grown on the sidewalls of the trench structure. The purpose of the slop liner is to reduce the electric field at the corners of the trench, where the gate oxide meets the silicon substrate. In a trench MOSFET, the gate electrode wraps around the vertical sides of the trench and meets the silicon substrate at the corners, forming a sharp angle. The electric field is concentrated at these corners, which can cause breakdown and device failure over time. By growing a thin layer of oxide on the sidewalls of the trench, the slop liner helps to smooth out the corners and distribute the electric field more evenly.

The electric field distribution in the MOSFET channel can be analyzed by dividing the channel into, e.g., three regions: the source end, the drain end, and the middle. The electric field distribution in each region is known as a "chain" electric field distribution because it resembles a chain-like structure. At the source end, the electric field is typically relatively uniform and relatively low due to the low voltage applied to the source. In the middle of the channel, the electric field is the highest and relatively uniform, resulting in the most significant current flow. At the drain end, the electric field decreases gradually due to the voltage drop across the channel, resulting in a reduced current flow. The chain electric field distribution in MOSFET affects the device's output characteristics, such as the threshold voltage, transconductance, and output resistance.

A drift region in the SGT-MOS helps to distribute voltage across the device and prevent voltage breakdown in highly doped regions of the anode and cathode. This may be achieved by reducing the electric field in the highly doped regions, as the potential difference is distributed across the longer, lightly doped drift region.

Known processes of manufacturing trenches in MOSFETs, e.g., for the manufacturing of SGT-MOS devices, are known to have disadvantages. For example, known processes for creating trenches typically requires multiple masks, which is time consuming process and costly. Furthermore, for optimal MOSFET performance and reliability, a substantially flat electric field distribution is desirable, but in practice this is difficult to achieve.

### Summary

A summary of aspects of certain examples disclosed herein is set forth below. It should be understood that these aspects are presented merely to provide the reader with a brief summary of these certain embodiments and that these aspects are not intended to limit the scope of this disclosure. Indeed, this disclosure may encompass a variety of aspects and/or a combination of aspects that may not be set forth.

A better FOM value, e.g., expressed as BV²/Rds(on), can be achieved by SGT-MOS compared with U-MOS. However, the chain electric field distribution in a normal SGT-MOS drift region may limit the FOM value. The present disclosure provides a solution to the above identified drawbacks of known manufacturing processes for creating trenches in MOSFETs. In particular, to improve the FOM value, a method for creating slop liner oxide in SGT-MOS is proposed that can achieve a substantially flat electric field distribution. Moreover, the method of the present disclosure enables semiconductor devices to be manufactures having trenches wherein a slop liner oxide can be formed using a reduces amount of masks, possibly only one mask.

The proposed process can advantageously be applied to various types of trench based devices, such as SGT-MOS, U-MOS, Insulated Gate Bipolar Transistors (IGBT) and trench diodes.

According to an aspect of the disclosure, a method of manufacturing a semiconductor device is proposed. The method may include the step of forming a region of semiconductor material having a surface. The method may further include the step of forming a trench extending from the surface into the region of semiconductor material. The method may further include the step of depositing a first oxide along an inner wall of the trench, the first oxide forming a first slob liner and having a first etch-back ratio. The method may further include the step of depositing a second oxide along the first oxide that has been deposited along the inner wall of the trench, the second oxide forming a second slob liner and having a second etch-back ratio that is higher than the first etch-back ratio. The method may further include the step of etching back the first oxide and the second oxide at the same time to form a slope morphology comprising the first oxide and the second oxide within the trench.

In an embodiment, the first oxide and the second oxide may be deposited using a thermal or sub-atmospheric chemical vapor deposition process.

In an embodiment, the etching back may include an isotropic etching process.

In an embodiment, the second etch-back ratio may be about 5 times the first etch-back ratio. In another embodiment, the second etch-back ratio may be about 10 times the first etch-back ratio.

In an embodiment, the method may further include, before the step of etching back, the step of performing a chemical mechanical polishing (CMP) and stopping the CMP at the first oxide.

In an embodiment, the method may further include the step of repeating the step of etching back to smoothen the slope morphology.

In an embodiment, the method may further include the step of depositing a third oxide along the slope morphology to form a second slope morphology comprising the first oxide, the second oxide and the third oxide within the trench. The third oxide may be same as the first oxide. The third oxide may be same as the second oxide.

In an embodiment, if the first oxide is a thermal oxide, then the second oxide may be one a sub-atmospheric chemical vapor deposition, SACVD, oxide.

In an embodiment, if the first oxide is a thermal oxide, then the second oxide may be a high-density plasma, HPD, oxide.

In an embodiment, if the first oxide is an SACVD oxide, then the second oxide may be a HPD oxide.

In an embodiment, the method may further include the step of depositing and etching back a source poly onto the slope morphology.

In an embodiment, the method may further include the step of forming in the trench one or more of: an input parasitic output capacitance; a gate oxide; a gate poly; a P-body; an N-source; a contact; and/or a metal layer.

In an embodiment, the semiconductor device may be an SGT-MOS.

In an embodiment, the semiconductor device may be a U-MOS.

In an embodiment, the semiconductor device may be an IGBT.

In an embodiment, the semiconductor device may be a trench diode.

According to an aspect of the disclosure, a semiconductor device is proposed that is manufactured using the method having one or more of the above identified features.

### Brief description of the Drawings

Embodiments of the present disclosure will now be described, by way of example only, with reference to the accompanying schematic drawings in which corresponding reference symbol indicate corresponding parts, in which:
Fig. 1 is a schematic 3-dimensional (3D) view of a trench gate power MOSFET;
Fig. 2 shows a cross sectional view of an SGT-MOSFET formed in an example embodiment of the present disclosure;
Figs. 3-8 show cross sectional views of an SGT-MOS during different manufacturing steps in an example embodiment of the present disclosure;
Fig. 9 shows a flow chart of a method of manufacturing a semiconductor device in an example embodiment of the present disclosure.

The figures are intended for illustrative purposes only, and do not serve as restriction of the scope of the protection as laid down by the claims.

### Detailed description

It will be readily understood that the components of the embodiments as generally described herein and illustrated in the appended figures could be arranged and designed in a wide variety of different configurations. Thus, the following more detailed description of various embodiments, as represented in the figures, is not intended to limit the scope of the present disclosure, but is merely representative of various embodiments. While the various aspects of the embodiments are presented in drawings, the drawings are not necessarily drawn to scale unless specifically indicated.

The described embodiments are to be considered in all respects only as illustrative and not restrictive. The scope of the present disclosure is, therefore, indicated by the appended claims rather than by this detailed description. All changes which come within the meaning and range of equivalency of the claims are to be embraced within their scope.

Reference throughout this specification to features, advantages, or similar language does not imply that all of the features and advantages that may be realized with the present disclosure should be or are in any single example of the present disclosure. Rather, language referring to the features and advantages is understood to mean that a specific feature, advantage, or characteristic described in connection with an embodiment is included in at least one embodiment of the present disclosure. Thus, discussions of the features and advantages, and similar language, throughout this specification may, but do not necessarily, refer to the same example.

Furthermore, the described features, advantages, and characteristics of the present disclosure may be combined in any suitable manner in one or more embodiments. One skilled in the relevant art will recognize, in light of the description herein, that the present disclosure can be practiced without one or more of the specific features or advantages of a particular embodiment. In other instances, additional features and advantages may be recognized in certain embodiments that may not be present in all embodiments of the present disclosure. Reference throughout this specification to "one embodiment," "an embodiment," or similar language means that a particular feature, structure, or characteristic described in connection with the indicated embodiment is included in at least one embodiment of the present disclosure. Thus, the phrases "in one embodiment," "in an embodiment," and similar language throughout this specification may, but do not necessarily, all refer to the same embodiment.

A trench gate MOSFET aims to make a complete chip conduct current vertically from one surface to the other so as to achieve a high drive capability. This may be realized by packing millions of trenches on a chip, deep enough to cross the oppositely doped 'body' region below the top surface. Each trench may house a gate dielectric and gate electrode to control the current conduction in its vicinity by the virtue of field effect.

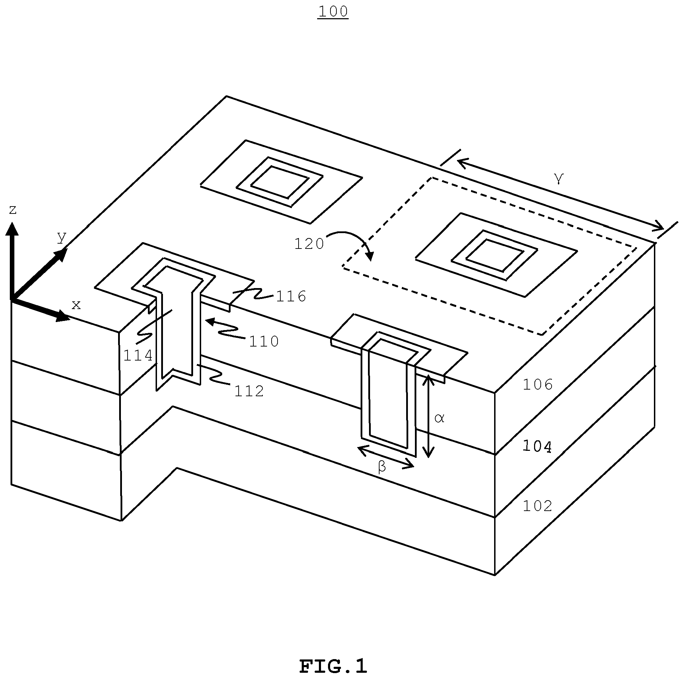

A schematic 3D view of a part of a trench gate MOSFET 100, with cut sections along two vertical cut planes, is shown in Fig. 1 indicating four adjacent cells 120 (each containing a trench 110). Similar to any other MOSFET, a trench MOSFET cell typically contains a drain 102, in this example a N+ drain, a gate 114, a source 116, in this example an N+ source, a body 106, in this example a P body, and the channel regions formed by the trenches 110, but exhibits a vertical direction of current flow. The inner wall of the trench 110 is typically covered by a gate oxide 112. All cells may be connected to work in parallel in order to reduce the Rds(on). In addition, there may be a lightly doped drain (LDD) region 104, in this example an N drift region, between the channel/trench 110 and the drain 102 to make it capable of sustaining large voltage in OFF-state condition. In the ON-state condition, the charge carriers may drift through the LDD region104 towards the drain 102 due to the potential difference.

The trench 110 extends from the surface 130 into the region of semiconductor material, in this example formed by the layers 102, 104 and 106. In this example, the trench 110 has a depth α of about 1.5 um and a width β of about 1 um. In this example, the cell 120 may have a width of about 2.5 um. These dimensions are presented as mere examples and the present disclosure is not limited to these dimensions.

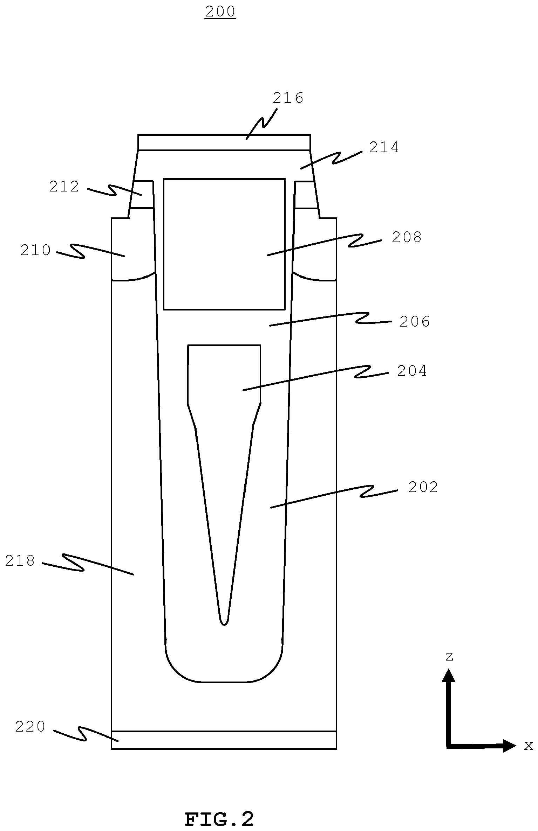

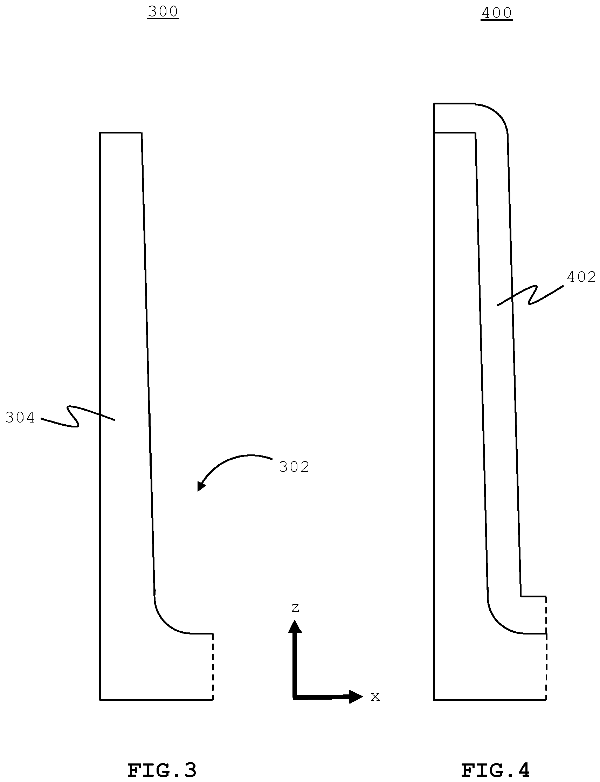

Fig. 2 shows an example SGT-MOSFET 200 formed in a trench, such as the trench 110 of Fig. 1. In Fig. 2, a cross section of a trench and some surrounding material is shown. The SGT-MOSFET 200 may be manufactured using a method of the present disclosure, which will be further described with Figs. 3-9. The SGT-MOSFET 200 may include a slope liner 202, a source poly 204, a further oxide portion 206, possibly from the same oxide as used for the slope liner 202, a gate poly 208, a P body 210, an N source 212, a gate oxide 214, possibly from the same oxide as used for the slope liner 202, and a metal source 216. The further oxide portion 206 and the gate oxide 214 may both be referred to as gate oxide. The trench forming the SGT-MOSFET 200 may be created in epitaxal layers 218 on top of a substrate 220.

Trenches in semiconductor devices, and in particular for trench based devices, such as SGT-MOS, U-MOS, IGBT transistors or trench diodes, may be formed using a method of the present disclosure as shown in Figs. 3-9. In Figs. 3-9, a left side of a cross sectional view of a trench is shown. I.e., a similar, mirrored right side could be drawn to form a complete cross section of the trench. In the z-direction, Figs. 3-9 may be similar to the trench 110 having a height of α. In the x-direction, Figs. 3-9 may be similar to half of the trench 110 having a with of β/2, The end result may be the SGT-MOSFET as shown in Fig. 2.

In a first step 300, shown in Fig. 3, a trench 302 may be formed in a region of semiconductor material 304. Here, the formed trench is an area void of any material.

In a next step 400, shown in Fig. 4, a liner oxide layer 402 may be grown in the trench 302 using thermal or SACVD.

With thermal deposition, a layer of oxide 402 may be deposited on the sidewalls and bottom of the trench 302 using a thermal deposition technique. This process typically begins with a substrate that has been patterned with trenches. The substrate may be cleaned and prepared to ensure that there are no contaminants or particles that could affect the quality of the oxide layer 402. The thermal deposition process involves heating the substrate and introducing a gas mixture that contains the precursor materials for the oxide layer 402. The gas mixture reacts on the heated surface of the substrate, producing a layer of oxide 402 that adheres to the substrate. During the deposition process, the thickness of the oxide layer 402 may be carefully controlled by adjusting the flow rate of the precursor gases and the temperature of the substrate. The goal is to produce a uniform layer of oxide that is conformal to the shape of the trench, with a consistent thickness across the entire surface.

SACVD is a type of chemical vapor deposition (CVD) technique used to deposit thin films of material onto a substrate. In the context of liner oxide layers in semiconductor devices, SACVD is a technique that may be used to deposit a thin layer of oxide 402 onto the sidewalls of a trench structure 302. SACVD is a low-pressure CVD technique that operates at sub-atmospheric pressures, typically between 50 and 100 torr. This technique allows for precise control over the deposition process, which can be critical for creating a uniform and conformal layer of oxide on the sidewalls of the trench. During SACVD, a precursor gas containing the material to be deposited is introduced into a chamber containing the substrate, which is typically heated to a high temperature. The precursor gas reacts with the surface of the substrate, depositing a thin layer of material onto the surface. In the case of a liner oxide layer, the precursor gas might contain a source of oxygen or another material that reacts with the silicon surface to form an oxide layer. By using SACVD to deposit a liner oxide layer 402 on the sidewalls of the trench 302, the electric field at the corners of the trench may be reduced, helping to improve the reliability and longevity of, e.g., a SGT-MOS device. The precise control provided by SACVD can help ensure that the liner oxide layer 402 is uniform and conformal, which is important for achieving consistent device performance.

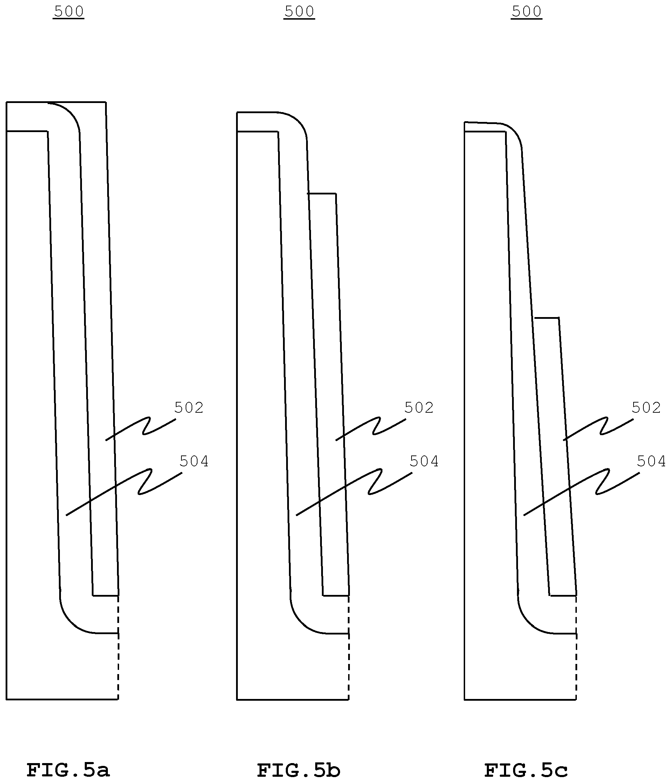

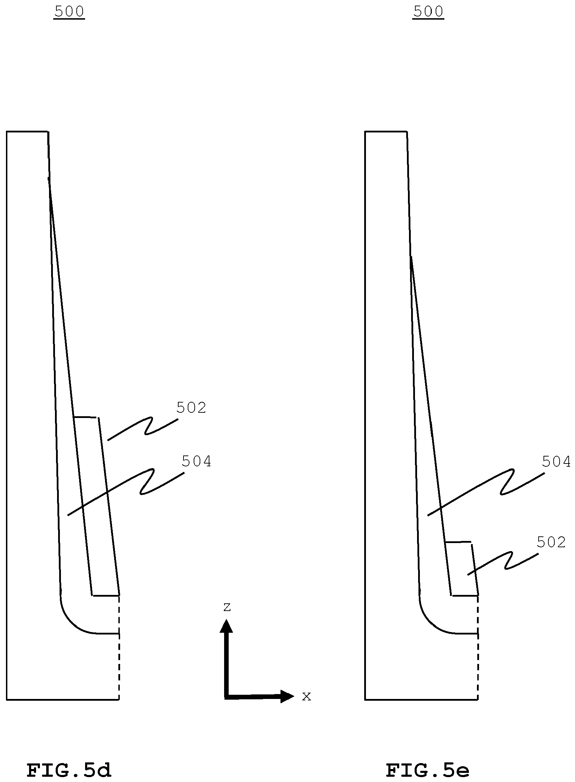

In a next step 500, shown in Figs. 5a-5e, the trench 302 may be filled with a further oxide via, e.g., a CVD process. The oxide used in this step 500, hereinafter referred to as "the second oxide" 502, may be different from the oxide used in step 400, hereinafter referred to as "the first oxide" 504, wherein the first oxide 504 forms the liner oxide layer 402 of Fig. 4. In particular, the second oxide 502 may have a faster etch back ratio than the first oxide 504, e.g., in a ratio of 5:1 or 10:1, or any other ratio with the second oxide having a higher etch back ratio. The specific etch back ratio may depend on the specific design of the trench based semiconductor device.

The deposited second oxide 502 may be etched back, e.g., using CMP, stopping at the first oxide 504. The result of this CMP is shown in Fig. 5a.

With CMP the surface of a substrate may be planarized or flattened. The process typically involves the use of a polishing pad and a slurry containing abrasive particles and chemicals. The pad and slurry are pressed against the substrate and rotated, while the substrate itself is also rotated, creating a chemical and mechanical polishing action that removes material from the high points of the substrate's surface.

Next, as shown in Figs. 5b-5e, the second oxide 502 and the first oxide 504 may be etched back at the same time, e.g., using isotropic etch back. The first oxide 504 may thus form a slop morphology with the second oxide 502 being consumed, made possible by the difference in etch back ratio.

Here, the term "slop morphology" refers to the shape and appearance of the liner oxide layer formed by the first and second oxides 502, 504 that lines the sidewalls and bottom of the trench. The purpose of this layer is to act as an insulator, isolating the conductive material deposited in the trench from the surrounding substrate. The morphology of the liner oxide layer can have an impact on the performance and reliability of the device. Ideally, the liner oxide layer should be uniform and smooth, with no voids or gaps that could allow the conductive material to leak or cause shorts.

The etch back ratio is the ratio of the amount of removed material removed from the bottom of a patterned features compared to the amount of material removed from the top of the features. This ratio may be affected by various factors such as the type of material being etched, the properties of the reactive gas, the power and pressure of the plasma, and the duration of the etching process. Here, the etch back ratio concerns the removal of the first oxide 504 and the second oxide 502.

With isotropic etch back, unwanted material may be removed from a substrate. This process involves the use of an isotropic etchant, which removes material from the substrate in a uniform and indiscriminate manner. Isotropic etching typically removes material uniformly from all directions.

After the deposition process, such as shown in step 400 and step 500, is complete, the oxide layer is typically annealed to improve its quality and stability. This may involve subjecting the substrate to a high temperature in a controlled environment, which allows the oxide layer to fully bond to the substrate and to remove any residual impurities or defects.

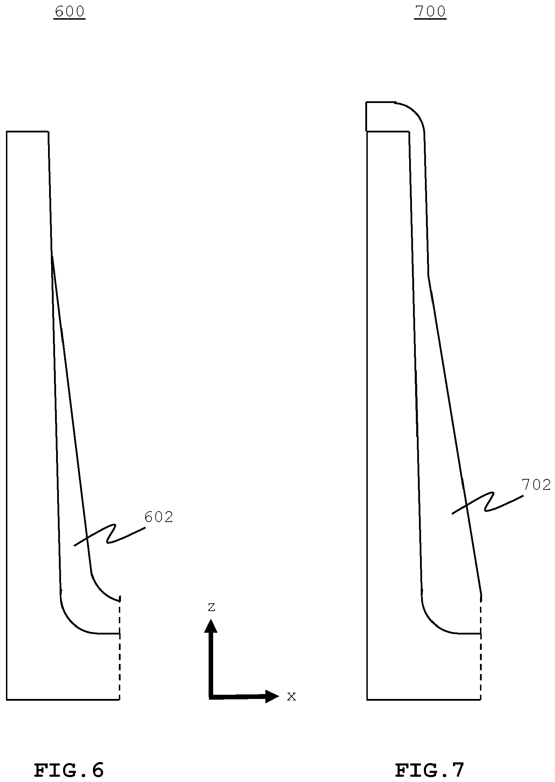

In a next step 600, shown in Fig. 6, the first oxide 504 and the second oxide 502 may be further etched back, e.g., using isotropic etch back, to create a smoothened slope morphology 602. This step 600 may be performed using wet etching.

Wet etching is a process of removing material from a substrate using a chemical solution. The chemical solution used for wet etching is often referred to as an etchant. The basic principle of wet etching is to dissolve the material that is being etched in a chemical solution. Hereto, the substrate may be immersed in the etchant solution for a specific amount of time, and the material that is exposed to the solution is gradually removed by the chemical reaction. The etching rate and selectivity of the etchant can be controlled by adjusting the concentration of the solution, the temperature, and the exposure time. The rate of etching is typically also influenced by the material being etched, here the first oxide 504 and the second oxide 502, and the crystal orientation of the substrate.

In a next step 700, shown in Fig. 7, a third oxide may be deposited into the trench to form the final liner oxide 702. The third oxide may be the same as the first oxide 504 or the second oxide 502, preferably the same as the first oxide 504. The third oxide may be deposited using a thermal process.

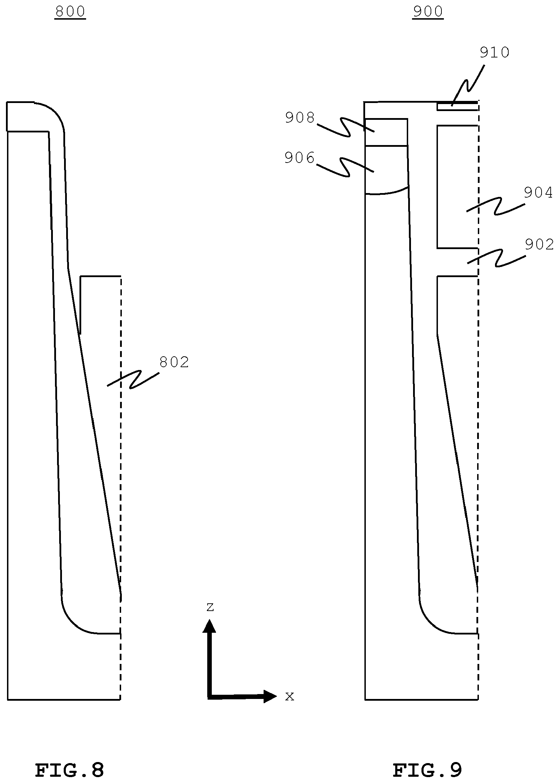

In a next step 800, shown in Fig. 8, a source poly 802 may be deposited into the trench and etched back.

The source poly is the portion of a polysilicon gate electrode that is connected to the source region. The source poly is typically formed by depositing a layer of polysilicon on top of the oxide layer, patterning the polysilicon to define the gate electrode, and then implanting dopants into the polysilicon to form the source poly. The source poly may then be annealed to activate the dopants and form a low-resistance contact between the source region and the gate electrode.

In next steps, the result of which is shown in Fig. 9, an input parasitic output (IPO) capacitance, a gate oxide 902, a gate poly 904, a P-body 906, an N-source 908, a contact 910 and/or a metal layer may be formed, thereby realizing, e.g., an SGT-MOSFET, such as shown in Fig. 2.

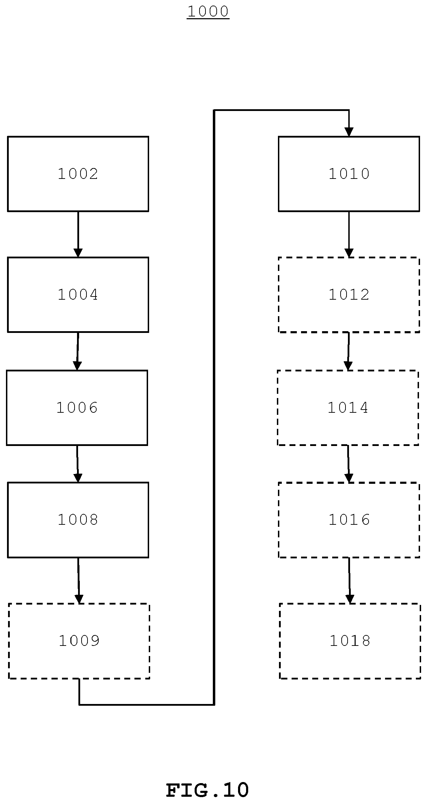

Fig. 10 shows an example embodiment of a method 1000 for manufacturing a semiconductor device 100, 200.

In step 1002, a region of semiconductor material 102-106, 218 having a surface may be formed.

In step 1004, a trench 302, 110 may be formed extending from the surface into the region of semiconductor material. Step 1004 may be similar to step 300.

In step 1006, a first oxide 504 may be deposited along an inner wall of the trench 302, 110. The first oxide may form a first slob liner 402 and may have a first etch-back ratio. Step 1006 may be similar to step 400.

In step 1008, a second oxide 502 may be deposited along the first oxide 504 that has been deposited along the inner wall of the trench 302, 110. The second oxide 502 may form a second slob liner and may have a second etch-back ratio that is higher than the first etch-back ratio. Step 1008 may result in Fig. 5a of step 500.

In step 1010, the first oxide and the second oxide may be etched back at the same time to form a slope morphology 602 including the first oxide 504 and the second oxide 502 within the trench 302, 110. Step 1010 may be similar to Figs. 5b-5e of step 500.

Before step 1010, a CMP may be performed, which stops at the first oxide 504. This is depicted as step 1009.

The process of etching back may be repeated to smoothen the slope morphology 602. This is depicted as step 1012. Step 1012 may be similar to step 600.

In step 1014, a third oxide may be deposited along the slope morphology 602 to form a second slope morphology 702 including the first oxide 504, the second oxide 502 and the third oxide within the trench 302, 110. Step 1014 may be similar to step 700. The third oxide may be one of the first oxide 504 and the second oxide 502.

In step 1016, a source poly 802 may be deposited and etched back onto the slope morphology 702. Step 1016 may be similar to step 800.

In step 1018, one or more of the following features may be formed in the trench 302, 110: an input parasitic output capacitance; a gate oxide 902, 206, 214; a gate poly 905, 208; a P-body 906, 210; an N-source 908, 212; a contact 910, 216; and/or a metal layer. Step 1018 may be similar to step 800.

Other features and advantages of the disclosure will be apparent from the description and the claims. Note that all optional features of the apparatus described above may also be implemented with respect to the method or process described herein and specifics in the examples may be used anywhere in one or more embodiments.

## Claims

1. A method of manufacturing a semiconductor device, comprising:
forming a region of semiconductor material having a surface;
forming a trench extending from the surface into the region of semiconductor material;
depositing a first oxide along an inner wall of the trench, the first oxide forming a first slob liner and having a first etch-back ratio;
depositing a second oxide along the first oxide that has been deposited along the inner wall of the trench, the second oxide forming a second slob liner and having a second etch-back ratio that is higher than the first etch-back ratio; and
etching back the first oxide and the second oxide at the same time to form a slope morphology comprising the first oxide and the second oxide within the trench.

2. The method according to claim 1, wherein the first oxide and the second oxide are deposited using a thermal or sub-atmospheric chemical vapor deposition process.

3. The method according to any one of the preceding claims, where the etching back comprises an isotropic etching process.

4. The method according to any one of the preceding claims, wherein the second etch-back ratio is one of: about 5 times the first etch-back ratio; about 10 times the first etch-back ratio.

5. The method according to any one of the preceding claims, further comprising:
before the step of etching back, performing a chemical mechanical polishing, CMP, and stopping the CMP at the first oxide.

6. The method according to any one of the preceding claims, further comprising:
repeating the step of etching back to smoothen the slope morphology.

7. The method according to any one of the preceding claims, further comprising:
depositing a third oxide along the slope morphology to form a second slope morphology comprising the first oxide, the second oxide and the third oxide within the trench

8. The method according to claim 7, wherein the third oxide is one of the first oxide and the second oxide.

9. The method according to any one of the preceding claims, wherein:
if the first oxide is a thermal oxide, then the second oxide is one of: a sub-atmospheric chemical vapor deposition, SACVD, oxide; and a high-density plasma, HPD, oxide;
if the first oxide is an SACVD oxide, then the second oxide is a HPD oxide.

10. The method according to any one of the preceding claims, further comprising:
depositing and etching back a source poly onto the slope morphology.

11. The method according to claim 10, further comprising:
forming in the trench one or more of: an input parasitic output capacitance; a gate oxide; a gate poly; a P-body; an N-source; a contact; a metal layer.

12. The method according to any one of the preceding claims, wherein the semiconductor device is one of: a Silicon-Gate Trench MOS, SGT-MOS; an Ultra-low ON-resistance MOS, U-MOS; an Insulated Gate Bipolar Transistor, IGBT, and a trench diode.

13. A semiconductor device manufactured using the method according to any one of the claims 1-12.

14. The semiconductor device according to claim 13, wherein the semiconductor device is one of: an Silicon-Gate Trench MOS, SGT-MOS; an Ultra-low ON-resistance MOS, U-MOS; an Insulated Gate Bipolar Transistor, IGBT, and a trench diode.
